(19) Europäisches Patentamt European Patent Office Office européen des brevets

(11) **EP 3 534 222 B1**

(12) **FASCICULE DE BREVET EUROPEEN**

(45) Date de publication et mention de la délivrance du brevet:
**05.11.2025 Bulletin 2025/45**

(21) Numéro de dépôt: **18159522.4**

(22) Date de dépôt: **01.03.2018**

(51) Classification Internationale des Brevets (IPC):
**G04B 17/06** *(2006.01)* **G04B 17/22** *(2006.01)*

(52) Classification Coopérative des Brevets (CPC):
**G04B 17/066; G04B 17/227**

(54) **PROCÉDÉ DE RÉALISATION D'UN OSCILLATEUR THERMO-COMPENSÉ**

HERSTELLUNGSVERFAHREN EINES THERMOKOMPENSIERTEN OSZILLATORS

METHOD FOR PRODUCING A THERMALLY COMPENSATED OSCILLATOR

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(43) Date de publication de la demande:
**04.09.2019 Bulletin 2019/36**

(73) Titulaire: **ROLEX SA**
**1211 Genève 26 (CH)**

(72) Inventeur: **HUNZIKER, Olivier**
**1800 Vevey (CH)**

(74) Mandataire: **Moinas & Savoye SARL**
**27, rue de la Croix-d'Or**
**1204 Genève (CH)**

(56) Documents cités:
EP-A1- 3 088 969   EP-A2- 2 063 325
WO-A2-2015/132259   CH-A2- 705 127

**Description**

L'invention concerne un procédé de fabrication d'un oscillateur d'une pièce d'horlogerie réalisé à partir d'un balancier et d'au moins deux parties de ressort, agencées en parallèle.

La régulation des montres mécaniques repose sur au moins un oscillateur mécanique, qui comprend généralement un volant d'inertie, appelé balancier, et un ressort enroulé en forme de spirale, appelé ressort spiral ou plus simplement spiral. Le spiral peut être fixé par une extrémité sur l'axe du balancier et par l'autre extrémité sur une partie fixe de la pièce d'horlogerie, comme un pont, sur lequel pivote l'axe du balancier. Le ressort spiral équipant les mouvements de montres mécaniques de l'état de la technique se présente sous la forme d'une lame métallique élastique ou d'une lame en silicium préférentiellement de section rectangulaire, dont la majeure partie est enroulée sur elle-même en spirale. Le balancier-spiral oscille autour de sa position d'équilibre (ou point mort). Lorsque le balancier quitte cette position, il arme le spiral. Cela crée un couple de rappel qui agit sur le balancier pour tendre à le faire revenir vers sa position d'équilibre. Comme il a acquis une certaine vitesse, donc une énergie cinétique, le balancier dépasse son point mort jusqu'à ce qu'un couple contraire du spiral l'arrête et l'oblige à tourner dans l'autre sens. De cette manière, le spiral régule la période d'oscillation du balancier.

La précision d'une montre mécanique dépend de la régularité des oscillations de son oscillateur formé par le balancier et le spiral. La fréquence de ces oscillations est paramétrée par l'inertie du balancier et la raideur du spiral, et il existe plusieurs manières d'atteindre précisément une fréquence donnée, par exemple au moyen d'éléments de réglage influençant la raideur du ressort, ou par un appairage adéquat d'un balancier particulier avec un spiral donné. Cet appairage permet également de limiter le réglage nécessaire.

Toutefois, lorsque la température varie, les dilatations thermiques respectives du spiral et du balancier modifient les propriétés de cet oscillateur, perturbant ainsi la précision de la montre.

Il existe des solutions de l'état de la technique qui essaient de réduire, voire de supprimer, les variations de fonctionnement d'un oscillateur avec la température. Une approche considère que la fréquence propre f d'un tel oscillateur dépend du rapport entre la constante du couple de rappel C, correspondant à la raideur angulaire du spiral, exercée par le spiral sur le balancier, et le moment d'inertie de ce dernier, par la relation suivante :

$$f = \frac{1}{2\pi}\sqrt{\frac{C}{I}}$$

En dérivant l'équation précédente par rapport à la température, nous obtenons la variation thermique relative de la fréquence propre de l'oscillateur, qui s'exprime par :

$$\frac{1}{f}\frac{df}{dT} = \frac{1}{2}\left[\frac{1}{E}\frac{dE}{dT} + 3\alpha_s - 2\alpha_b\right]$$

où E est le module de Young du spiral de l'oscillateur,

$\frac{1}{f}\frac{df}{dT}$ est le coefficient thermique de l'oscillateur, aussi dénommé simplement par l'acronyme CT,

$\frac{1}{E}\frac{dE}{dT}$ est le coefficient thermique du module de Young du spiral de l'oscillateur, aussi appelé par l'acronyme CTE,

$\alpha_s$ et $\alpha_b$ sont respectivement les coefficients de dilatation thermique du spiral et du balancier de l'oscillateur.

Différentes solutions de l'état de la technique cherchent à annuler la valeur du coefficient thermique CT de l'oscillateur en choisissant un CTE du spiral adapté à cet effet, pour thermo-compenser l'oscillateur.

Le document CH705127A2 décrit un résonateur thermo-compensé de type balancier spiral. Ce balancier est associé à deux ressorts spiraux disposés en parallèle. Chaque spiral a un coefficient thermique variant en fonction de la température dans le sens opposé de l'autre spiral, chaque spiral étant défini pour atteindre simultanément une thermo-compensation et des propriétés élastiques satisfaisantes.

Le document EP3088969A1 décrit un spiral thermo-compensé constitué d'une alternance de parties de spire en matériau différent, en silicium monocristallin, en oxyde de silicium et en silicium polycristallin. Il divulgue de plus une section variable du spiral.

Le document EP2063325A2 s'intéresse au problème technique d'équilibrage d'un spiral de balancier spiral. Pour cela, il décrit un balancier spiral comprenant deux ressort spiraux agencés dans un même plan, montés en parallèle.

Le but de l'invention est de fournir un oscillateur pour pièce d'horlogerie issu d'une méthode de combinaison de ses composants permettant à la fois de garantir la thermo-compensation de l'oscillateur mais également d'améliorer l'appairage du balancier et de son ressort de rappel angulaire pour atteindre une fréquence d'oscillation donnée de manière fiable.

A cet effet, l'invention repose sur l'association d'un ressort de rappel angulaire comprenant un agencement d'au moins deux parties distinctes dont les variations de raideur angulaire en fonction de la température sont différentes, avec un balancier, dont l'inertie peut être connue, pour former un oscillateur d'une pièce d'horlogerie, de sorte que ledit oscillateur d'une pièce d'horlogerie puisse être thermo-compensé tout en oscillant à une fréquence donnée sans nécessiter de réglage, ou tout du moins en minimisant les opérations de réglage nécessaires.

Ainsi, l'invention repose sur un procédé de fabrication d'un oscillateur d'une pièce d'horlogerie réalisé à partir d'un balancier et d'au moins deux parties de ressort, agencées en parallèle, selon la revendication 1 annexée.

Selon un mode de réalisation proche de l'invention, le procédé comprend les étapes suivantes :

- Choisir les matériaux du balancier et desdites parties du ressort spiral, lesdites parties pouvant être en des matériaux différents ;
- Choisir la fréquence f de l'oscillateur ;
- Mesurer ou considérer l'inertie I du balancier ;
- Calculer les raideurs angulaires Ci de chaque partie i du ressort telles que

$$f = \frac{1}{2\pi}\sqrt{\frac{\sum_i C_i}{I}}$$

et qui annulent également l'équation

$$\frac{1}{f}\frac{df}{dT} = \frac{1}{2}\left(\frac{\sum_i C_i(CTE_i + 3\alpha_{s,i})}{\sum_i C_i} - 2\alpha_{bal}\right) \; ;$$

- Choisir des parties i de ressort dont les raideurs angulaires respectives sont proches des valeurs Ci calculées ;
- Assembler lesdites au moins deux parties choisies du ressort au balancier.

L'invention est définie par les revendications.

Les objets, caractéristiques et avantages de la présente invention seront exposés en détail dans la description suivante de modes de réalisation particuliers faits à titre non-limitatif en relation avec la figure jointe qui représente schématiquement un oscillateur d'une pièce d'horlogerie comportant un ressort de rappel angulaire de type ressort spiral, avec agencement en parallèle de deux parties de spiral selon un mode de réalisation de l'invention.

L'objectif de l'invention est de proposer un oscillateur thermo-compensé ne nécessitant pas ou très peu de réglage. Pour cela, il est recherché une solution approchant au maximum une valeur du coefficient thermique (CT) nulle pour l'oscillateur, dont les oscillations deviennent ainsi indépendantes ou quasi-indépendantes de la température, et une combinaison d'un volant d'inertie que nous appellerons « balancier » et d'un ressort de rappel pour garantir la fréquence requise qui est préalablement choisie et donc imposée.

Le mode de réalisation de l'invention qui va être décrit repose sur une construction d'un oscillateur obtenu par l'association d'au moins deux parties de ressort de rappel angulaire distinctes, choisies pour former un ressort de rappel angulaire qui peut être couplé avec un balancier prédéfini pour obtenir un oscillateur thermo-compensé, et plus spécifiquement avec un balancier dont l'inertie aura été mesurée de manière à garantir la fréquence propre choisie de l'oscillateur quelle que soit la température.

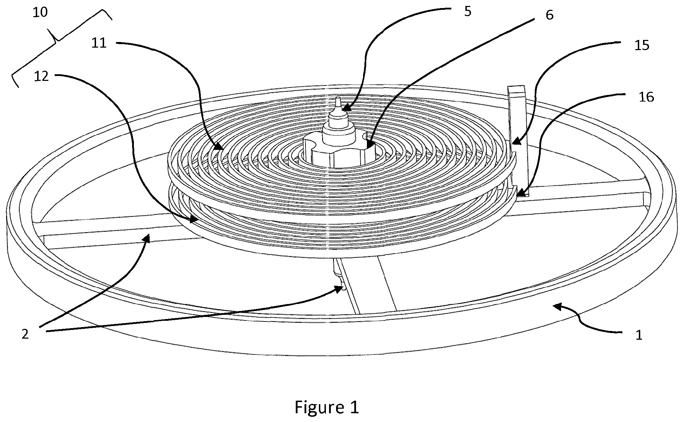

L'invention va être illustrée plus en détail avec un mode de réalisation, représenté par la figure 1, dans lesquel un oscillateur pour pièce d'horlogerie se présente sous la forme d'un ensemble balancier-ressort. Le ressort de rappel angulaire 10 de l'oscillateur se présente sous la forme d'un « bi-spiral », comprenant un agencement en parallèle de deux spiraux 11, 12. Nous entendons par l'expression « en parallèle » un accrochage de chacun des deux spiraux d'une part à l'arbre 5 de balancier, par exemple au moyen d'une ou de deux viroles 6, et d'autre part au pont de balancier, par exemple au moyen d'un ou de deux pitons reliés à leurs extrémités périphériques 15, 16 respectives. Ce ressort de rappel angulaire agit sur un volant d'inertie ou balancier 1, relié à l'arbre 5 par des bras 2. L'ensemble forme un oscillateur mécanique.

Dans cette réalisation, chaque partie distincte du ressort de rappel angulaire est formée d'un spiral ou d'une portion de spiral, comprenant une ou plusieurs spires ou portions de spire. On définit par spire une portion du spiral s'étendant selon un arc angulaire de l'ordre de 360°, et par portion de spire une portion s'étendant selon un arc angulaire inférieur à 360°. De plus, chaque spiral, spire ou portion de spire de ces modes de réalisation de l'invention se présente sous la forme d'une lame élastique préférentiellement de section rectangulaire, enroulée sur elle-même en spirale. Nous dénommerons e l'épaisseur et h la hauteur de cette section rectangulaire. De plus, nous dénommerons L la longueur curviligne d'un spiral, spire ou portion de spire. Cette longueur curviligne est définie comme l'écart entre deux abcisses curvilignes, sur la fibre neutre de la spire. Enfin, nous appelerons r le rayon de giration du balancier et m sa masse.

Un ensemble de spiraux est constitué de spiraux, de spires ou de portions de spires réalisés dans un même matériau. Un lot de spiraux, de spires ou de portions de spires est un ensemble de spiraux, de spires ou de portions de spires considérés comme identiques à la dispersion géométrique de fabrication près.

Nous entendons ici par « matériau » soit un matériau homogène unique, soit un matériau composite issu d'une combinaison de matériaux selon un agencement donné. A titre d'exemple non limitatif, un spiral en silicium monocristallin revêtu sur toutes ses faces d'un oxyde de silicium d'une épaisseur donnée est considéré comme un matériau composite.

Dans le cas de deux spiraux (ou spires ou portions de spire) agencés en parallèle, la contribution d'un spiral à la thermo-compensation est pondérée par sa contribution relative au couple de rappel, donc à la raideur angulaire.

Le couple de rappel du ressort de rappel est la somme des couples des deux spiraux. La fréquence propre f de l'oscillateur peut alors s'écrire par l'équation suivante :

$$f = \frac{1}{2\pi}\sqrt{\frac{C_1 + C_2}{I}} \qquad (1)$$

où I est l'inertie du balancier et Ci la raideur angulaire d'un spiral i.

Dans le cas général, l'équation (1) devient :

$$f = \frac{1}{2\pi}\sqrt{\frac{\sum_i C_i}{I}}.$$

L'inertie I et la raideur angulaire Ci, qui est définie pour de la flexion pure, se calculent comme suit :

$$I = mr^2 \quad \text{et} \quad C_i = \frac{E_i e_i^{\,3} h_i}{12\, l_i}$$

où m est la masse du balancier, r le rayon de giration du balancier,

Ei le module élastique du matériau du spiral i, ei l'épaisseur de la lame du spiral i, hi la hauteur de la lame du spiral i, et li la longueur curviligne du spiral i.

En introduisant les termes I et Ci dépendants de la température et en dérivant l'équation (1) par rapport à la température, on obtient - après réarrangement - l'équation suivante :

$$\frac{1}{f}\frac{df}{dT} = \frac{1}{2}\left(\frac{1}{\sum_i C_i}\sum_i \frac{dC_i}{dT} - \frac{2}{r}\frac{dr}{dT}\right) \quad (2)$$

Soit pour le cas d'un spiral, l'équation (2) devient :

$$\frac{1}{f}\frac{df}{dT} = \frac{1}{2}\left(\frac{1}{\sum_i C_i}\sum_i C_i\left(\frac{1}{E_i}\frac{dE_i}{dT} + \frac{3}{e_i}\frac{de_i}{dT} + \frac{1}{h_i}\frac{dh_i}{dT} - \frac{1}{l_i}\frac{dl_i}{dT}\right) - \frac{2}{r}\frac{dr}{dT}\right)$$

En considérant des matériaux homogènes et isotropes, ou en utilisant pour chaque matériau un coefficient de dilatation apparent adapté, le coefficient de dilatation thermique des matériaux $\alpha = 1/x \cdot dx/dT$ est identique pour les directions x explicitées ci-dessus (r, L, e et h). D'autre part, en définissant le terme CTE comme étant le coefficient thermique du module élastique 1/E.dE/dT, l'équation précédente peut être simplifiée comme suit :

$$\frac{1}{f}\frac{df}{dT} = \frac{1}{2}\left(\frac{\sum_i C_i(CTE_i + 3\alpha_{s,i})}{\sum_i C_i} - 2\alpha_{bal}\right) \quad (2')$$

où $\alpha_{s,i}$ et $\alpha_{bal}$ sont respectivement les coefficients de dilatation thermique du spiral i et du balancier de l'oscillateur.

Comme ce premier mode de réalisation comprend deux spiraux (i=2), l'équation précédente devient :

$$\frac{1}{f}\frac{df}{dT} = \frac{1}{2}\left(\frac{C_1}{C_1+C_2}(CTE_1 + 3\alpha_{s,1}) + \frac{C_2}{C_1+C_2}(CTE_2 + 3\alpha_{s,2}) - 2\alpha_{bal}\right)$$ (3)

Dès lors que l'on a défini le matériau du balancier, la valeur de $\alpha_{bal}$ est connue et les résultats satisfaisant à l'équation (3) peuvent être représentés par une droite dans le plan [$C_1$ ;$C_2$]. Il existe dès lors une multitude de paires de solutions $C_1$, $C_2$ qui satisferont à cette équation. L'homme de métier saura choisir les matériaux du balancier et celui ou ceux des spiraux (ou spires ou portions de spires) de manière adéquate pour permettre de trouver des solutions à cette équation.

Si l'on connaît l'inertie du balancier, il sera alors possible, dans le même plan, de tracer à l'aide de l'équation (1) une autre droite correspondant à son annulation. Il suffira alors de choisir des parties de spiral dont les raideurs angulaires $C_1$ et $C_2$ correspondent à l'intersection de ces deux droites pour garantir la réalisation d'un oscillateur à la fréquence requise, thermo-compensé, puis d'assembler les deux parties pour former le spiral, qui pourra ensuite être assemblé au balancier pour former l'oscillateur.

En remarque, dans le cas d'un matériau anisotrope, par exemple le silicium, le coefficient thermique varie selon la direction cristalline de la sollicitation du matériau et varie donc sur la longueur du spiral (ou de la spire ou portion de spire). De même, dans le cas d'un matériau hétérogène, comme le silicium oxydé, le coefficient thermique varie à l'intérieur de la section de la lame. Un CTE équivalent ou apparent, connu de l'homme du métier, peut être ainsi considéré pour un spiral, ou une spire ou une portion de spire, formé en un matériau anisotrope et/ou hétérogène.

Par exemple, si le balancier est en CuBe2, sachant que la dilatation thermique du CuBe2 est positive (+17 ppm/°C), il faut choisir les matériaux des deux spiraux de manière à ce qu'au moins un des deux termes CTE+$\alpha_s$ soit positif pour annuler l'équation, notamment qu'au moins un des deux termes CTE+$\alpha_s$ soit supérieur à au moins deux fois $\alpha_{bal}$ pour annuler l'équation. Il suffira ensuite d'ajuster les dimensions des deux spiraux, en particulier leur raideur angulaire, pour obtenir le résultat escompté, à savoir une thermo-compensation de l'oscillateur.

A titre d'exemple, pour un oscillateur à 4Hz, nous prenons d'abord un balancier en CuBe2 d'une inertie mesurée à 14.28 mg·cm². Ensuite, nous considérons un lot de spiraux S1 en silicium monocristallin, découpés dans un plan {100}, de propriétés et dimensions suivantes : Emoyen=148 GPa, $\alpha$=2.6 ppm/°C, CTE=-64.3 ppm/°C, hauteur de 150 microns, longueur active de 150 mm et dont l'épaisseur est proche de 36.5 $\mu$m. Nous considérons de plus un deuxième lot S2 de spiraux en SiO$_2$ amorphe, de propriétés et dimensions suivantes : E=72.4 GPa, $\alpha$=0.382 ppm/°C, CTE=210 ppm/°C, et de mêmes dimensions que les spiraux du premier lot, qui seront assemblés en parallèle sur le balancier pour réaliser l'oscillateur.

La fréquence de 4 Hz sera obtenue en choisissant parmi les deux lots de spiraux un premier spiral S1a dont la raideur angulaire C1 est de 5.97·10$^{-7}$ Nm (correspondant à une épaisseur de 36.445 $\mu$m), et un deuxième spiral S2a dont la raideur angulaire C2 est de 3.05·10$^{-7}$ Nm (correspondant à une épaisseur de 36.975 $\mu$m). Ces deux spiraux seront assemblés pour former un spiral, qui sera à son tour assemblé au balancier pour former un oscillateur à la fréquence de 4Hz, thermo-compensé.

Pour un matériau composite tel que défini plus haut, le CTE est donc calculé à partir des CTE de chacun des matériaux utilisés, pondéré par l'agencement géométrique des différentes matériaux, de manière connue de l'homme de métier.

Le coefficient thermique de l'oscillateur, donné par l'équation (3), permet après réarrangement de définir la valeur cible de $CTE_2 + 3\alpha_2$ :

$$CTE_2 + 3\alpha_{s2} = \frac{2\alpha_{bal}(2\pi f)^2 I - C_1(CTE_1 + 3\alpha_{s1})}{(2\pi f)^2 I - C_1}$$

Ainsi, si on connaît pour un spiral sa raideur et sa variation de raideur selon la température (CTE + 3$\alpha$), il devient possible de choisir un deuxième spiral permettant d'annuler le CT. Ces deux spiraux pourront ensuite être appairés à un balancier d'inertie adéquate pour atteindre la fréquence cible.

A titre d'exemple constitué de matériaux composites, pour un oscillateur à 4Hz constitué d'un balancier en CuBe2 d'une inertie mesurée à 14.12 mg·cm², nous considérons un lot de spiraux Si en silicium monocristallin découpés dans le plan {100}, revêtus sur toutes leurs faces d'une couche d'oxyde de silicium SiO$_2$ amorphe de 3.5° $\mu$m d'épaisseur de manière à former un spiral composite de hauteur de 157 microns, longueur active de 150 mm et dont l'épaisseur est proche de 39° $\mu$m. La raideur angulaire de ces spiraux est mesurée individuellement et l'ensemble des spiraux se situent dans une plage proche de 4.5·10$^{-7}$ Nm.

Le CTE de ces spiraux composites peut être calculé à partir des valeurs de CTE du silicium et du silicium oxydé amorphe ainsi que de la géométrie du spiral (épaisseurs respectives de silicium et d'oxyde).

La fréquence de 4 Hz sera obtenue en choisissant parmi ce lot de spiraux composites un premier spiral dont la raideur angulaire C1 est de 4.8665·10⁻⁷ Nm et un deuxième spiral dont la raideur angulaire C2 est de 4.0533·10⁻⁷ Nm. Ces deux spiraux seront assemblés pour former un spiral, qui sera à son tour assemblé au balancier pour former un oscillateur à la fréquence de 4Hz, thermo-compensé.

Une variante de ce premier mode de réalisation repose sur un ressort de rappel angulaire d'un oscillateur formé par l'agencement en parallèle de trois spiraux provenant d'au moins deux lots de spiraux et formant trois parties distinctes dudit ressort de rappel. Cette variante permet d'augmenter le nombre de combinaisons de parties de spiral de manière à pouvoir s'affranchir totalement du réglage de l'oscillateur et/ou de pouvoir assortir des parties de spiral dont les propriétés et/ou dimensions sont très différentes, mais également d'effectuer une thermocompensation de deuxième ordre, utile dans le cas de l'utilisation de matériaux dont les variations de coefficient thermique en fonction de la température présentent elles aussi des signes opposés.

Ainsi, l'invention présente l'avantage de permettre de fabriquer un oscillateur performant pour pièce d'horlogerie, en augmentant la flexibilité d'appairage du balancier et du spiral de manière à atteindre avec précision une fréquence d'oscillation donnée, permettant de limiter, voire de supprimer les réglages ultérieurs, tout en formant un oscillateur qui conserve sa fréquence d'oscillation donnée malgré les changements de température.

Naturellement, l'invention ne se limite pas aux modes de réalisation décrits ci-dessus, ni aux exemples détaillés, ni même aux équations simples mentionnées en amont. Elle peut notamment comporter plus de trois parties distinctes de ressort de rappel.

D'autre part, les parties distinctes du ressort de rappel peuvent se trouver ou non dans un même plan. Une lame d'au moins une partie distincte du ressort de rappel, par exemple se présentant en forme de spires ou de portions de spire, peut présenter une section de toute forme, non nécessairement rectangulaire comme dans les modes de réalisation précédents. De plus, cette section peut rester constante sur toute sa longueur, ou au contraire varier. Enfin, les parties distinctes du ressort de rappel peuvent se présenter sous la forme d'un spiral, comme envisagé dans les exemples précédents, ou en variante sous toute autre forme, notamment sous la forme d'une lame rectiligne.

Nous entendons finalement par parties distinctes du ressort de rappel deux ou plus éléments distincts, qui sont positionnés dans un même agencement pour former ensemble le ressort de rappel. Dans cet agencement, ces parties distinctes participent ainsi de manière complémentaire à la même fonction de ressort de rappel, tout en apportant un effet de thermo-compensation de l'oscillateur. Elles sont choisies de manière à combiner cet effet de thermo-compensation au choix précis de la fréquence de l'oscillateur. Ces parties distinctes peuvent être assemblées les unes aux autres par tout moyen de fixation, ou simplement positionnées à proximité. Dans tous les cas, ces parties distinctes sont agencées de sorte à pouvoir coopérer avec un même volant d'inertie, et former un seul oscillateur de pièce d'horlogerie. Ces parties distinctes ne sont donc pas simplement deux zones d'un même ressort qui serait monobloc, indissociable, et/ou monolithique, même si ces deux zones peuvent présenter des matériaux différents.

Dès lors qu'il est possible de combiner au moins deux spiraux pour réaliser un oscillateur thermocompensé, il devient également possible de combiner lesdits deux spiraux à un balancier particulier pour ajuster la fréquence de l'oscillateur.

Le balancier est par exemple réalisé en un alliage cuivre-béryllium, de manière connue (aussi appelé simplement alliage CuBe2), comme cela a été illustré dans les modes de réalisation précédents. En variante, d'autres matériaux peuvent être utilisés pour le balancier.

Avantageusement, au moins deux parties distinctes du ressort de rappel angulaire se présentent en deux matériaux différents. Une partie distincte peut être monobloc. Elle peut être en un seul matériau, ou comprendre plusieurs matériaux différents, par exemple comprendre des zones en matériaux différents.

Dans tous les cas, le ressort de rappel de l'invention comprend au moins deux parties distinctes dont les variations de raideur angulaire Ci en fonction de la température, selon le terme CTE+3αs, compensent la dilatation thermique du balancier associé, de sorte que ledit oscillateur comprenant ce ressort de rappel d'une pièce d'horlogerie est thermo-compensé.

Naturellement, une partie distincte du ressort de rappel peut se trouver dans tout autre matériau. De préférence, un matériau insensible aux champs magnétiques est privilégié, pour éviter des perturbations de la marche liées à l'aimantation résiduelle des composants soumis à un champ magnétique.

Au moins une partie distincte du ressort de rappel peut comprendre tout ou partie du silicium monocristallin quelle que soit son orientation, du silicium polycristallin, du silicium amorphe, du quartz, de l'oxyde de silicium amorphe, du silicium dopé quels que soient le type et le niveau de dopage, du silicium poreux, un alliage à base de Fe-Ni possédant un coefficient thermique du module de Young (ci-après CTE) positif, et/ou un alliage Nb-Zr-O.

Au moins une partie distincte du ressort de rappel peut comprendre un ou des matériaux isotropes. En variante, elle peut comprendre un matériau anisotrope, par exemple le silicium, dont le coefficient thermique varie selon la direction cristalline de la sollicitation du matériau et varie donc sur la longueur du spiral. Le silicium peut, par exemple, être revêtu d'une couche d'oxyde de silicium. Dans le cas d'un matériau hétérogène comme le silicium oxydé, le coefficient thermique varie à l'intérieur de la section de la lame du ressort de rappel. Le terme dC/dT, ou le CTE équivalent ou apparent, connus de l'homme du métier, sont ainsi considérés pour une partie distincte du ressort de rappel formée en un matériau anisotrope et/ou hétérogène, et les calculs précédents restent applicables sur cette base.

Le mode de réalisation décrit précédemment définit différentes étapes qui sont exécutées dans l'ordre tel que décrit. Toutefois, l'invention peut en variante être mise en œuvre en utilisant des approches différentes, consistant notamment à inverser l'ordre de certaines des étapes décrites.

Le procédé décrit comprend le choix préalable d'un balancier, dont l'inertie I est ensuite mesurée.

De plus, les matériaux du balancier et des parties de ressort sont de même avantageusement choisis au préalable, parmi des matériaux qui possèdent des propriétés naturelles connues de l'homme du métier de telle sorte à garantir le succès de la mise en œuvre des étapes suivantes. En variante toutefois, le matériau peut être choisi a posteriori ou simultanément au choix d'autres paramètres, comme la géométrie, du balancier et/ou des parties de ressort.

Ainsi, de nombreux autres modes de réalisation peuvent être définis, reposant sur un procédé de fabrication d'un oscillateur d'une pièce d'horlogerie selon la revendication 1 annexée.

Le procédé comprend avantageusement une étape préalable consistant à choisir les matériaux du balancier et des parties de ressort.

L'étape de choix (b) comprend avantageusement le choix d'un balancier d'inertie I et de parties de ressort de raideurs angulaires $C_i$ qui respectent les équations suivantes :

$$f = \frac{1}{2\pi}\sqrt{\frac{\sum_i C_i}{I}}$$

et

$$\frac{1}{f}\frac{df}{dT} = \frac{1}{2}\left(\frac{\sum_i C_i(CTE_i + 3\alpha_{s,i})}{\sum_i C_i} - 2\alpha_{bal}\right) = 0$$

Ainsi, l'invention présente l'avantage de permettre de fabriquer un oscillateur performant pour pièce d'horlogerie, en augmentant la flexibilité d'appairage du balancier et du spiral de manière à atteindre avec précision une fréquence d'oscillation donnée. La flexibilité est accrue par la possibilité de choisir le balancier et les parties de ressort parmi des lots existants, sans nécessiter une fabrication spécifique à chaque nouvel agencement horloger.

## Revendications

1. Procédé de fabrication d'un oscillateur d'une pièce d'horlogerie réalisé à partir d'un balancier (1) et d'au moins deux parties de ressort (11, 12), agencées en parallèle, **caractérisé en ce qu'**il comprend les étapes suivantes :

   a. Choisir la fréquence f de l'oscillateur ;
   b. Choisir un balancier parmi un lot existant, dont l'inertie I est ensuite mesurée, et des parties de ressort, consistant à sélectionner les parties de ressort existantes les plus appropriées parmi au moins deux lots ou au moins deux ensembles de parties de ressort existantes, de sorte que l'inertie du balancier et les raideurs angulaires des parties de ressort permettent de former un oscillateur de fréquence f choisie et de sorte que les variations de raideur angulaire des parties de ressort en fonction de la température sont aptes à thermo-compenser l'oscillateur ;
   c. Assembler lesdites parties de ressort choisies au balancier choisi.

2. Procédé de fabrication d'un oscillateur selon la revendication précédente, **caractérisé en ce que** l'étape de choix (b) comprend la mesure individuelle de la raideur angulaire des parties de ressort existantes parmi lesdits au moins deux lots ou au moins deux ensembles de parties de ressort.

3. Procédé de fabrication d'un oscillateur selon l'une des revendications précédentes, **caractérisé en ce qu'**il comprend une étape préalable consistant à choisir les matériaux du balancier et des parties de ressort.

4. Procédé de fabrication d'un oscillateur selon l'une des revendications précédentes, **caractérisé en ce qu'**il comprend une étape préalable consistant à choisir au moins deux parties de ressort en deux matériaux différents ou en un seul matériau.

5. Procédé de fabrication d'un oscillateur selon l'une des revendications précédentes, **caractérisé en ce que** l'étape de choix (b) comprend le choix d'un balancier d'inertie I et de parties de ressort de raideurs angulaires $C_i$ qui respectent les équations suivantes :

$$f = \frac{1}{2\pi}\sqrt{\frac{\sum_i C_i}{I}}$$

et

$$\frac{1}{f}\frac{df}{dT} = \frac{1}{2}\left(\frac{\sum_i C_i\left(CTE_i + 3\alpha_{s,i}\right)}{\sum_i C_i} - 2\alpha_{bal}\right) = 0$$

6. Procédé de fabrication d'un oscillateur selon l'une des revendications précédentes, **caractérisé en ce que** le balancier est en CuBe2.

7. Procédé de fabrication d'un oscillateur selon l'une des revendications précédentes, **caractérisé en ce que** l'étape de choix (b) des parties de ressort consiste à sélectionner au moins deux parties de ressort présentant des variations de leur raideur angulaire Ci en fonction de la température de signes opposés.

8. Procédé de fabrication d'un oscillateur selon l'une des revendications précédentes, **caractérisé en ce que** les parties de ressort sont en des matériaux choisis notamment parmi du silicium monocristallin quelle que soit son orientation cristalline, du silicium polycristallin, du silicium amorphe, du quartz, de l'oxyde de silicium amorphe, du silicium dopé quels que soient le type et le niveau de dopage, un alliage à base de Fe-Ni possédant un CTE positif, et/ou un alliage Nb-Zr-O.

9. Procédé de fabrication d'un oscillateur selon l'une des revendications précédentes, **caractérisé en ce que** les parties de ressort se présentent sous la forme d'une portion de spire ou d'une ou plusieurs spires, de lames rectilignes, ou d'une combinaison de portion de spires, de spires et de lames rectilignes, et/ou **en ce qu'**une ou plusieurs parties de ressort comportent une section variant sur leur longueur.

10. Procédé de fabrication d'un oscillateur selon l'une des revendications 1 à 8, **caractérisé en ce que** l'étape de choix (b) comprend les étapes suivantes :

- choisir un balancier et mesurer ou estimer son inertie I ; puis
- Déterminer les raideurs angulaires $C_i$ de chaque partie i du ressort telles que

$$f = \frac{1}{2\pi}\sqrt{\frac{\sum_i C_i}{I}}$$

et qui annulent également l'équation

$$\frac{1}{f}\frac{df}{dT} = \frac{1}{2}\left(\frac{\sum_i C_i\left(CTE_i + 3\alpha_{s,i}\right)}{\sum_i C_i} - 2\alpha_{bal}\right) = 0 \; ;$$

puis
- choisir des parties de ressort dont les raideurs angulaires respectives sont proches des valeurs de raideurs angulaires $C_i$.

**Patentansprüche**

1. Herstellungsverfahren eines Oszillators einer Uhr, der aus einer Unruh (1) und mindestens zwei parallel angeordneten Federteilen (11, 12) hergestellt wird, **dadurch gekennzeichnet, dass** es die folgenden Schritte umfasst:

a. Wählen der Frequenz f des Oszillators;

b. Wählen einer Unruh aus einem vorhandenen Satz, deren Trägheit I anschließend gemessen wird, und der Federteile, darin bestehend, die am besten geeigneten vorhandenen Federteile aus vorhandenen mindestens zwei Sätzen oder mindestens zwei Gesamtheiten von Federteilen so auszuwählen, dass die Trägheit der Unruh und die Winkelsteifigkeiten der Federteile ermöglichen, einen Oszillator mit der gewählten Frequenz f zu bilden, und so, dass die Veränderungen der Winkelsteifigkeit der Federteile in Abhängigkeit von der Temperatur geeignet sind, eine Temperaturkompensation des Oszillators zu bewirken;

c. Zusammenbauen der gewählten Federteile mit der gewählten Unruh.

2. Herstellungsverfahren eines Oszillators nach dem vorhergehenden Anspruch, **dadurch gekennzeichnet, dass** der Schritt des Wählens (b) die individuelle Messung der Winkelsteifigkeit der vorhandenen Federteile aus den mindestens zwei Sätzen oder mindestens zwei Gesamtheiten von Federteilen umfasst.

3. Herstellungsverfahren eines Oszillators nach einem der vorhergehenden Ansprüche, **dadurch gekennzeichnet, dass** es einen vorausgehenden Schritt umfasst, der darin besteht, die Materialien der Unruh und der Federteile zu wählen.

4. Herstellungsverfahren eines Oszillators nach einem der vorhergehenden Ansprüche, **dadurch gekennzeichnet, dass** es einen vorausgehenden Schritt umfasst, der darin besteht, mindestens zwei Federteile aus zwei verschiedenen Materialien oder aus einem einzigen Material zu wählen.

5. Herstellungsverfahren eines Oszillators nach einem der vorhergehenden Ansprüche, **dadurch gekennzeichnet, dass** der Schritt des Wählens (b) die Wahl einer Unruh mit der Trägheit I und von Federteilen mit Winkelsteifigkeiten $C_i$ umfasst, die die folgenden Gleichungen erfüllen:

$$f = \frac{1}{2\pi}\sqrt{\frac{\sum_i C_i}{I}}$$

und

$$\frac{1}{f}\frac{df}{dT} = \frac{1}{2}\left(\frac{\sum_i C_i\left(CTE_i + 3\alpha_{s,i}\right)}{\sum_i C_i} - 2\alpha_{bal}\right) = 0$$

6. Herstellungsverfahren eines Oszillators nach einem der vorhergehenden Ansprüche, **dadurch gekennzeichnet, dass** die Unruh aus CuBe2 besteht.

7. Herstellungsverfahren eines Oszillators nach einem der vorhergehenden Ansprüche, **dadurch gekennzeichnet, dass** der Schritt des Wählens (b) der Federteile darin besteht, mindestens zwei Federteile auszuwählen, die Veränderungen ihrer Winkelsteifigkeit Ci in Abhängigkeit von der Temperatur mit entgegengesetzten Vorzeichen aufweisen.

8. Herstellungsverfahren eines Oszillators nach einem der vorhergehenden Ansprüche, **dadurch gekennzeichnet, dass** die Federteile aus Materialien bestehen, die insbesondere aus monokristallinem Silizium, unabhängig von seiner Kristallorientierung, polykristallinem Silizium, amorphem Silizium, Quarz, amorphem Siliziumoxid, dotiertem Silizium, unabhängig vom Dotierungstyp und Dotierungsgrad, einer Legierung auf Fe-Ni-Basis mit einem positiven CTE und/oder einer Nb-Zr-O-Legierung gewählt sind.

9. Herstellungsverfahren eines Oszillators nach einem der vorhergehenden Ansprüche, **dadurch gekennzeichnet, dass** die Federteile in der Form eines Windungsabschnitts oder einer oder mehrerer Windungen, von geraden Lamellen oder einer Kombination eines Windungsabschnitts, von Windungen und von geraden Lamellen vorliegen, und/oder dadurch, dass ein oder mehrere Federteile einen Querschnitt aufweisen, der entlang ihrer Länge variiert.

10. Herstellungsverfahren eines Oszillators nach einem der Ansprüche 1 bis 8, **dadurch gekennzeichnet, dass** der Schritt des Wählens (b) die folgenden Schritte umfasst:

- Wählen einer Unruh und Messen oder Schätzen ihrer Trägheit I; danach
- Bestimmen der Winkelsteifigkeiten $C_i$ jedes Teils i der Feder, so dass gilt

$$f = \frac{1}{2\pi}\sqrt{\frac{\sum_i C_i}{I}}$$

und dass außerdem die Gleichung

$$\frac{1}{f}\frac{df}{dT} = \frac{1}{2}\left(\frac{\sum_i C_i(CTE_i + 3\alpha_{s,i})}{\sum_i C_i} - 2\alpha_{bal}\right) = 0$$

erfüllt ist; danach
- Wählen der Federteile, deren jeweilige Winkelsteifigkeiten den Winkelsteifigkeitswerten $C_i$ nahekommen.

**Claims**

1. A process for manufacturing a timepiece oscillator made up of a balance and of at least two spring portions that are arranged in parallel, **characterized in that** it comprises the following steps:

   a. choosing the frequency f of the oscillator;
   b. choosing a balance among an existing batch, which inertia I is then measured, and spring portions, by selecting the most appropriate existing spring portions among at least two batches or at least two sets of existing spring portions, so that the inertia of the balance and the angular stiffnesses of the spring portions allow an oscillator of chosen frequency f to be formed and so that the variations in angular stiffness of the spring portions as a function of temperature are able to thermo-compensate the oscillator;
   c. assembling said chosen spring portions with the chosen balance.

2. The process for manufacturing an oscillator as claimed in the preceding claim, **characterized in that** the choice of step b) comprises the individual measurement of the angular stiffness of existing spring portions among said at least two batches or at least two sets of existing spring portions.

3. The process for manufacturing an oscillator as claimed in one of the preceding claims, **characterized in that** it comprises a prior step consisting in choosing the materials of the balance and of the spring portions.

4. The process for manufacturing an oscillator as claimed in one of the preceding claims, **characterized in that** it comprises a prior step consisting in choosing at least two spring portions being made of different or same materials.

5. The process for manufacturing an oscillator as claimed in one of the preceding claims, **characterized in that** the choosing step, step (b), comprises choosing a balance of inertia I and spring portions of angular stiffnesses $C_i$ that respect the following equations:

$$f = \frac{1}{2\pi}\sqrt{\frac{\sum_i C_i}{I}}$$

and

$$\frac{1}{f}\frac{df}{dT} = \frac{1}{2}\left(\frac{\sum_i C_i(CTE_i + 3\alpha_{s,i})}{\sum_i C_i} - 2\alpha_{bal}\right) = 0$$

6. The process for manufacturing an oscillator as claimed in one of the preceding claims, **characterized in that** the balance is made of CuBe2.

7. The process for manufacturing an oscillator as claimed in one of the preceding claims, **characterized in that** step (b) of choosing the spring portions consists in selecting at least two spring portions having variations in their angular stiffness Ci as a function of temperature of opposite signs.

8. The process for manufacturing an oscillator as claimed in one of the preceding claims, **characterized in that** the spring portions are made of materials in particular chosen among single-crystal silicon whatever its crystal orientation, polysilicon, amorphous silicon, quartz, amorphous silicon oxide, doped silicon whatever the dopant type and concentration, an alloy based on Fe-Ni possessing a positive CTE, and/or an Nb-Zr-O alloy.

9. The process for manufacturing an oscillator as claimed in one of the preceding claims, **characterized in that** the spring portions take the form of a turn segment or of one or more turns, of rectilinear blades, or of a combination of turn segments, of turns and rectilinear blades, and/or **in that** one or more spring portions have a cross section that varies over their length.

10. The process for manufacturing an oscillator as claimed in one of claims 1 to 8, **characterized in that** the choosing step, step (b), comprises the following steps:

- choosing a balance and measuring or estimating its inertia I; then
- determining angular stiffnesses $C_i$ for each portion i of the spring such that

$$f = \frac{1}{2\pi}\sqrt{\frac{\sum_i C_i}{I}}$$

and that the following equation also equal zero

$$\frac{1}{f}\frac{df}{dT} = \frac{1}{2}\left(\frac{\sum_i C_i(CTE_i + 3\alpha_{s,i})}{\sum_i C_i} - 2\alpha_{bal}\right) = 0;$$

then
- choosing spring portions which respective angular stiffnesses are close to the angular-stiffness values $C_i$.

Figure 1

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- CH 705127 A2
- EP 3088969 A1
- EP 2063325 A2